Europäisches Patentamt

European Patent Office

Office européen des brevets

(11) Veröffentlichungsnummer: **0 467 467 A2**

## EUROPÄISCHE PATENTANMELDUNG

(21) Anmeldenummer: **91201832.2**

(51) Int. Cl.⁵: **G01R 33/54**

(22) Anmeldetag: **12.07.91**

(30) Priorität: **20.07.90 DE 4023128**

(43) Veröffentlichungstag der Anmeldung:
**22.01.92 Patentblatt 92/04**

(84) Benannte Vertragsstaaten:
**DE FR GB NL**

(71) Anmelder: **Philips Patentverwaltung GmbH
Wendenstrasse 35 Postfach 10 51 49
W-2000 Hamburg 1(DE)**

(84) **DE**

Anmelder: **N.V. Philips' Gloeilampenfabrieken
Groenewoudseweg 1**

**NL-5621 BA Eindhoven(NL)**

(84) **FR GB NL**

(72) Erfinder: **McKinnon, Graeme, Dr.
Wiesliacher 12
CH-8053 Zürich(CH)**
Erfinder: **Bösiger, Peter, Dr. Priv.-Doz.
Rebbergstrasse 73
CH-5400 Ennetbaden(CH)**

(74) Vertreter: **Hartmann, Heinrich, Dipl.-Ing. et al
Philips Patentverwaltung GmbH
Wendenstrasse 35 Postfach 10 51 49
W-2000 Hamburg 1(DE)**

(54) **Kernresonanz-Spektroskopieverfahren.**

(57) Die Erfindung betrifft ein Kernresonanz-Spektroskopieverfahren, bei dem eine Sequenz - vorzugsweise mehrmals - auf einen Untersuchungsbereich einwirkt, die zwei frequenzselektive, die Wasserkomponente nicht anregende Hochfrequenzimpulse umfaßt, zwischen denen sich ein 180°-Hochfrequenzimpuls befindet. Eine solche Sequenz kann gegen Unvollkommenheiten des 180°-Impulses dadurch unempfindlicher gemacht werden, daß dem zweiten frequenzselektiven Hochfrequenzimpuls ein weiterer frequenzselektiver, die Wasserkomponente nicht anregender Hochfrequenzimpuls folgt und daß zwischen dem zweiten frequenzselektiven Hochfrequenzimpuls und dem weiteren Hochfrequenzimpuls wie nach dem weiteren Hochfrequenzimpuls ein magnetisches Gradientenfeld derart ein- und ausgeschaltet wird, daß die zeitlichen Integrale über dieses Gradientenfeld vor- und nach dem weiteren Hochfrequenzimpuls einander gleich sind.

FIG.4

Die Erfindung betrifft ein Kernresonanz-Spektroskopieverfahren, bei dem eine Sequenz - vorzugsweise mehrmals - auf einen Untersuchungsbereich einwirkt, die zwei frequenzselektive, die Wasserkomponente nicht anregende Hochfrequenzimpulse umfaßt, zwischen denen sich ein 180°-Hochfrequenzimpuls befindet sowie eine Anordnung zur Durchführung eines solchen Verfahrens.

Ein solches Verfahren ist aus der EP-A 322 006 sowie aus der Zeitschrift "MAGNETIC RESONANCE IN MEDICINE" 8, 355-361 (1988) bekannt. Je nach Phasenlage des zweiten frequenzselektiven Hochfrequenzimpulses läßt sich mit dem bekannten Verfahren entweder Milchsäure (Lactat) oder Fett (Lipide) in einem Untersuchungsbereich nachweisen, der neben Fett und Milchsäure Wasser enthält.

Der 180°-Hochfrequenzimpuls ist dabei ein sogenannter harter Impuls, dessen Frequenzspektrum die Larmorfrequenz von Wasser einschließt. Im Idealfall - wenn dieser Impuls die Kernmagnetisierung jeweils überall um genau 180° kippt - wird die Kernmagnetisierung von an Wasser gebundenen Protonen im Untersuchungsbereich dadurch nicht angeregt. In der Praxis und insbesondere bei Untersuchungen am lebenden Körper ergeben sich jedoch geringe Abweichungen von diesem Winkel, die wegen der relativ hohen Wasserkonzentration im menschlichen Körper den Nachweis der Laktatbzw. Lipidkomponenten erschweren, wenn nicht gar unmöglich machen.

Es ist zur Unterdrückung der störenden Wasserkomponenten bekannt, in jeder zweiten Sequenz die Phasenlage des 180°-Impulses - bezogen auf den ersten frequenzselektiven Impuls - zu invertieren. Dadurch wird das Vorzeichen des im Kernresonanzsignal enthaltenen auf das Wasser zurückzuführenden Anteils von Sequenz zu Sequenz invertiert, so daß diese Anteile sich nach einer Summation der Kernresonanzsignale kompensieren. Dieses Verfahren ist aber gegen Bewegungen im Untersuchungsbereich empfindlich, wie sie bei der spektroskopischen Untersuchung am menschlichen Körper auftreten können.

Es ist Aufgabe der vorliegenden Erfindung, das eingangs genannte Verfahren auf andere Weise so auszugestalten, daß trotz des Vorhandenseins von Wasser im Untersuchungsbereich der spektroskopische Nachweis von Laktat bzw. Lipiden möglich ist.

Diese Aufgabe wird erfindungsgemäß dadurch gelöst, daß dem zweiten frequenzselektiven Hochfrequenzimpuls ein weiterer frequenzselektiver, die Wasserkomponente nicht anregender Hochfrequenzimpuls folgt und daß zwischen dem zweiten frequenzselektiven Hochfrequenzimpuls und dem weiteren Hochfrequenzimpulse wie nach dem weiteren Hochfrequenzimpuls ein magnetisches Gradientenfeld derart ein- und ausgeschaltet wird, daß die zeitlichen Integrale über dieses Gradientenfeld vor- und nach dem weiteren Hochfrequenzimpuls einander gleich sind.

Der weitere Hochfrequenzimpuls in Verbindung mit dem magnetischen Gradientenfeld vor und nach diesem Impuls wirkt sich auf die Kernmagnetisierung der an Wasser gebundenen Protonen einerseits und der an Milchsäure bzw. Fett gebundenen Protonen andererseits in unterschiedlicher Weise aus. Die an Wasser gebundenen Protonen "sehen" diesen Impuls nicht, und daher wird ihre Kernmagnetisierung - falls sie durch den 180°-Impuls angeregt wurde - dephasiert, so daß, sie keinen Beitrag zum Kernresonanzsignal aus dem Untersuchungsbereich liefern kann. Da der weitere Hochfrequenzimpuls aber Frequenzkomponenten mit der Larmorfrequenz der an Milchsäure bzw. Fett gebundenen Protonen aufweist, wirkt er zusammen mit dem vorgehenden und dem nachfolgenden magnetischen Gradientenfeld als refokussierender Impuls, d.h. die Dephasierung, die die Kernmagnetisierung dieser Protonen vor dem weiteren Impuls erfährt, wird durch die Rephasierung aufgehoben, die sie nach diesem Impuls erfahren. Im Ergebnis bewirkt der weitere Hochfrequenzimpuls in Verbindung mit dem magnetischen Gradientenfeld also eine "Wasserunterdrückung".

Eine Weiterbildung der Erfindung sieht vor, daß der weitere Hochfrequenzimpuls ein 180°-Impuls ist. Zwar kann der Impuls auch einen anderen Flipwinkel als 180° aufweisen,doch ergibt sich bei 180° die größte Amplitude des (von Milchsäure bzw. Fett herrührenden) Kernresonanzsignals.

Eine Weiterbildung der Erfindung sieht vor, daß dem weiteren frequenzselektiven Hochfrequenzimpuls drei 180°-Hochfrequenzimpulse in Anwesenheit jeweils eines magnetischen Gradientenfeldes folgen und daß die Gradienten der während dieser 180°-Hochfrequenzimpulse wirksamen magnetischen Gradientenfelder senkrecht zueinander stehen. Damit ist es möglich, ein bestimmtes Volumen zu selektieren und nur für dieses Volumen den Gehalt an Lipiden oder Laktat zu bestimmen (lokalisierte Spektroskopie).

Eine Anordnung zur Durchführung des erfindungsgemäßen Verfahrens, die versehen ist mit Mitteln zur Erzeugung eines homogenen stationären Magnetfeldes, mit einer Hochfrequenzspulenanordnung zum Erzeugen von Hochfrequenzimpulsen und zum Aufnehmen der als Reaktion darauf im Untersuchungsbereich erzeugten Kernresonanzsignale, einer Verarbeitungseinheit zum Ableiten eines Spektrums aus den aufgenommenen Kernresonanzsignalen und mit einer Steuereinheit ist dadurch gekennzeichnet, daß die Steuereinheit so ausgebildet ist, daß sie mindestens eine Sequenz erzeugt, bei der auf einen ersten frequenzselekti-

ven 90°-Hochfrequenzimpuls zur Wasserunterdrük- kung ein 180°-Impuls folgt, dem seinerseits ein zweiter frequenzselektiver 90°-Hochfrequenzimpuls zur Wasserunterdrückung folgt, wonach ein magnetisches Gradientenfeld ein- und ausgeschaltet wird, worauf ein weiterer frequenzselektiver Hochfrequenzimpuls folgt, wonach das magnetische Gradientenfeld erneut ein- und ausgeschaltet wird.

Die Erfindung wird nachstehend anhand der Zeichnung näher erläutert. Es zeigen

Fig. 1 ein Gerät für medizinische Kernresonanzuntersuchungen, mit dem das erfindungsgemäße Verfahren durchführbar ist,

Fig. 2 ein Blockschaltbild eines solchen Gerätes,

Fig. 3 die Lage der Spektralkomponenten von Wasser, Milchsäure und Lipiden,

Fig. 4 den zeitlichen Verlauf einer erfindungsgemäßen Sequenz für lokalisierte Spektroskopie.

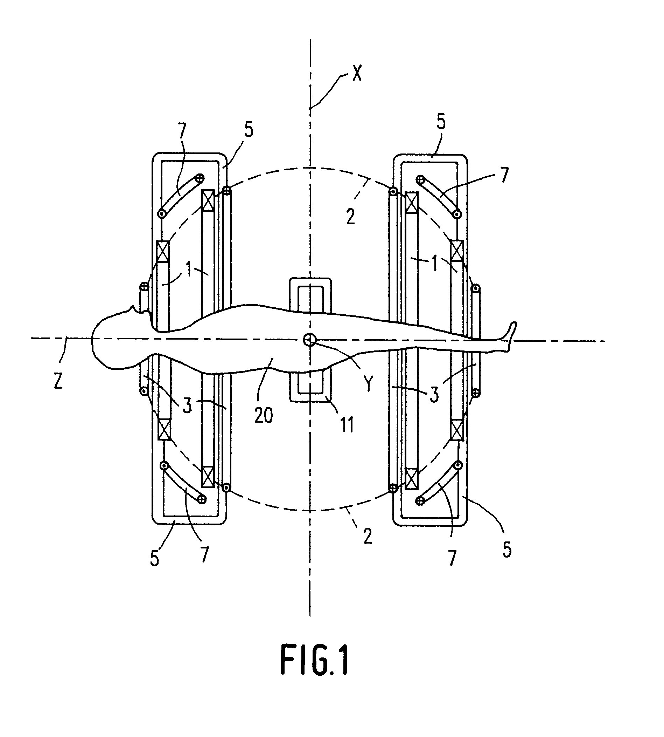

Das in Fig. 1 schematisch dargestellte Kernspin-Untersuchungsgerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld (d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Figur 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung 1 bestimmt. Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes verlaufendes hochfrequentes Magnetfeld erzeugt wird. Der Hochfrequenzspule wird während jedes Hochfrequenzimpulses ein hochfrequenter modulierter Strom von einem Hochfrequenzgenerator zugeführt. Im Anschluß an eine Sequenz dient die Hochfrequenzspule 11 oder eine gesonderte Hochfrequenz- Empfangsspule zum Empfangen der im Untersuchungsbereich erzeugten Kernresonanzsignale.

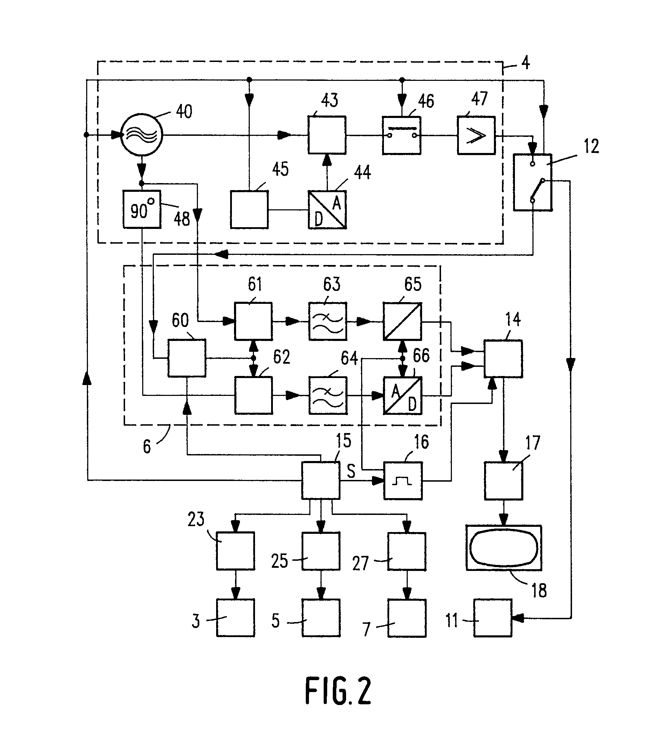

Fig. 2 zeigt ein vereinfachtes Blockschaltbild dieses Kernspin-Untersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz durch eine Steuereinheit 15 digital steuerbaren Hochfrequenzoszillator 40, der Schwingungen mit einer Frequenz entsprechend der Larmorfrequenz der anzuregenden Atomkerne bei der von den Spulen 1 erzeugten Feldstärke liefert. Die Larmorfrequenz f berechnet sich bekanntlich nach der Beziehung f = cB, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe wird ein zweites Eingangssignal von einem Digital-Analog-Wandler 44 zugeführt, dessen Ausgang mit einem digitalen Speicher 45 verbunden ist. Aus dem Speicher wird - gesteuert durch die Steuereinrichtung - eine Folge von ein Hüllkurvensignal darstellenden digitalen Datenworten ausgelesen.

Die Mischstufe 43 verarbeitet die ihr zugeführten Eingangssignale so, daß sie an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem die in der Hochfrequenzspule 11 induzierten Kernresonanzsignale zugeführt werden, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von 90° besteht. Diese Phasenverschiebung wird mit Hilfe eines 90° Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben wwerden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die im Speicher 14 gespeicherten Datenworte werden einem Rechner 17 zugeführt, der daraus durch eine diskrete Fourier-Transformation das Spektrum der Kernmagnetisierung ermittelt und an einer geeigneten Wiedergabeeinheit, z.B. einem Monitor 18, ausgibt.

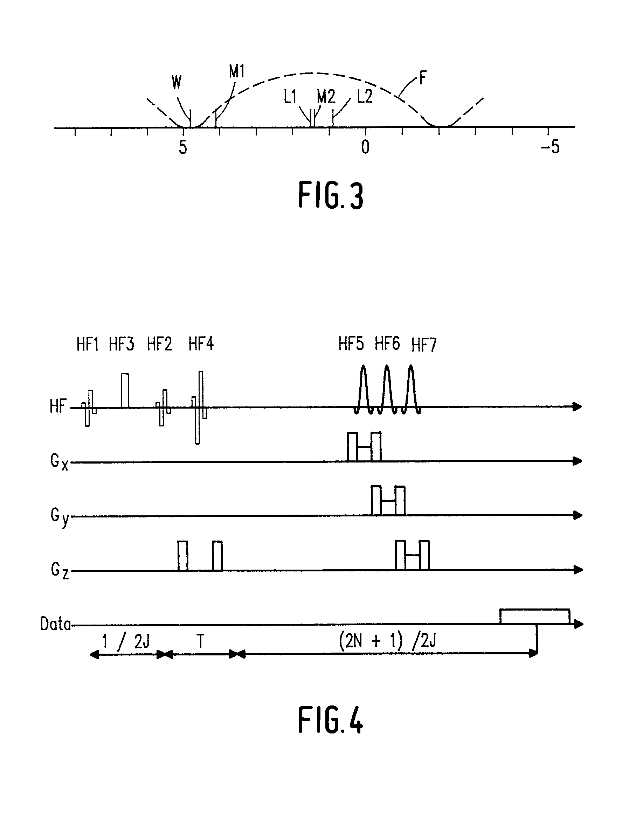

Fig. 3 zeigt die Lage der für die spektroskopische Untersuchung wesentlichen Komponenten auf einer Frequenzskala, die auf die Larmorfrequenz von TMS (Tetramethylsilan) normierte Frequenzabweichung gegenüber der Larmorfrequenz von TMS angibt. Die Larmorfrequenz von TMS liegt dabei also bei Null, während die Larmorfrequenz W von Wasser bei 4,7 ppm liegt. Milchsäure enthält eine Linie M2 bei ca. 1,3 ppm, die von der $CH_3$-Gruppe von Laktat herrührt. Diese $CH_3$-Gruppe ist skalar mit einer CH-Gruppe des Milchsäuremoleküls gekoppelt, deren Larmorfrequenz M1 bei 4,1 ppm liegt. In unmittelbarer Nähe der Komponente M2 befindet sich eine Linie L1 (bei ca. 1,4 ppm), die von einer $CH_2$-Gruppe des Fettmoleküls herrührt, die mit einer $CH_3$-Gruppe dieses Moleküls bei ca. 0,9 ppm gekoppelt ist. In der Umgebung der Linie M2 gibt es noch weitere ungekoppelte Linien des Lipid-Frequenzspektrums, die in Fig. 3 nicht näher dargestellt sind.

In Fig. 3 ist außerdem durch eine gestrichelte Linie F das Frequenzspektrum eines binomialen Hochfrequenzimpulses schematisch angedeutet. Derartige Hochfrequenzimpulse werden bei dem anhand von Fig. 4 näher erläuterten Verfahren als frequenzselektive Impulse eingesetzt. Man erkennt, daß die Frequenzkomponenten dieser Impulse bei der Wasserlinie W den Wert 0 haben und etwa bei der Linie M2 von Milchsäure ihr Maximum. Infolgedessen wird dadurch die Kernmagnetisierung von Wasser - und de facto auch nicht die der Milchsäurekomponente M1 angeregt, jedoch die Milchsäurekomponente M2, die gekoppelten Lipidkomponenten L1 und L2 und die anderen in Fig. 3 nicht dargestellten Lipidkomponenten in diesem Frequenzbereich.

Gemäß Fig. 4 zeigt den zeitlichen Verlauf der Signale bei einer Sequenz, die für die lokalisierte Spektroskopie u.a. auch im Bereich des menschlichen Herzens geeignet ist. Die Sequenz wird dabei genügend oft wiederholt, um ein ausreichendes Signal/Rauschverhältnisses zu erreichen. Die Sequenz beginnt mit einem frequenzselektiven 90°-Hochfrequenzimpuls HF1, einem binomialen $(1\bar{3}3\bar{1})$-Impuls (erste Zeile). Ein solcher binomialer Hochfrequenzimpuls besteht bekanntlich aus einer Folge von Teilpulsen, deren zugeordnete Flipwinkel im gleichen Verhältnis zueinander stehen wie die Binomialkoeffizienten. Dabei sind der zeitliche Abstand der Teilpulse voneinander und die Frequenz der innerhalb der Teilpulse wirksamen Trägerschwingung so bemessen sind, daß das Frequenzspektrum des binomialen Hochfrequenzimpulses bei der Larmorfrequenz W von Wasser verschwindet und zumindest annähernd bei der Larmorfrequenz M2 von Laktat sein Maximum aufweist.

Der Hochfrequenzimpuls HF2, dessen Mitte von der Mitte des Impulses HF1 den Abstand 1/2 J hat, wobei J die skalare Kopplungskonstante von Milchsäure ist (ca. 7 Hz), hat den gleichen zeitlichen Verlauf wie HF1 - wenn man einmal von der Phasenlage der Trägerschwingung absieht. Zwischen diesen beiden Hochfrequenzimpulsen umfaßt die Sequenz einen harten (breitbandigen) 180°-Hochfrequenzimpuls HF3. Die während des Hochfrequenzimpulses HF3 wirksame Trägerschwingung muß die gleiche oder die entgegengesetzte Phasenlage haben wie während des ersten bzw. dritten Teilpulses von HF1. Wenn HF2 die gleiche Phasenlage hat wie HF1, werden alle Komponenten außer M2 unterdrückt, so daß Laktat nachgewiesen werden kann. Ist die Phasenlage von HF2 gegenüber derjenigen von HF1 jedoch um 90° versetzt, werden M2 und auch die gekoppelten Lipidkomponenten L1, L2 unterdrückt, so daß ein Nachweis der ungekoppelten Lipidkomponenten L1, L2 möglich ist. Im einzelnen ist dies in den eingangs genannten Veröffentlichungen beschrieben.

Erfindungsgemäß wird nach dem Hochfrequenzimpuls HF2 noch ein weiterer frequenzselektiver Hochfrequenzimpuls HF4 erzeugt, dessen Spektrum bei der Wasserlinie W verschwindet und bei M2 sein Maximum hat - entsprechend Kurve F in Fig. 3. Während jedoch HF1 und HF2 als 90°-Impulse wirksam sind, ist HF4 vorzugsweise ein 180°-Hochfrequenzimpuls, beispielsweise in Form eines binomialen ($2\overline{6}6\overline{2}$)-Impulses. Zwischen den Hochfrequenzim- pulsen HF2 und HF4 sowie nach HF4 wird ein magnetisches Gradientenfeld ein- und ausgeschaltet - in diesem Fall das Feld Gz. Die Größe des Gradienten und der zeitlicheVerlauf sind dabei so gewählt, daß das zeitliche Integral über Gz vor HF4 so groß ist wie nach HF4.

Die an Wasser gebundenen und durch die Unvollkommenheit des 180°-Impulses HF3 teilweise angeregten Protonen "sehen" den Impuls HF4 wegen seiner Frequenzselektivität nicht, so daß auf sie nur das Gradientenfeld Gz einwirkt, das sie dephasiert. Für die Komponenten L1, L2, M2 und die anderen Komponenten in diesem Frequenzbereich hingegen wirkt HF4 als refokussierender Impuls, so daß die Dephasierung, die diese Komponenten durch das Gradientenfeld Gz vor dem Impuls HF4 erfahren, durch die entsprechende Rephasierung infolge des nach HF4 wirksamen Feldes Gz wieder kompensiert wird. Insgesamt werden die Komponenten L1, M2 usw. durch HF4 in Verbindung mit dem Gradientenfeld Gz vor und nach diesem Impuls praktisch nicht beeinflußt, während die insbesondere durch HF3 angeregten Wasserkomponenten dadurch dephasiert werden. Die Folgen der unerwünschten Wasseranregung durch HF3 sind daher nicht so gravierend wie bei einer Sequenz ohne HF4 und Gz.

Um Laktat bzw. Lipide nur in einem allseits begrenzten Teilvolumen des Untersuchungsbereichs nachweisen zu können, umfaßt die Sequenz im Anschluß an den Hochfrequenzimpuls HF4 drei 180°-Hochfrequenzimpulse HF5, HF6 und HF7, die je von einem magnetischen Gradientenfeld Gx, Gy und Gz (zweite, dritte und vierte Zeile von Fig. 4) begleitet sind, deren Gradienten senkrecht zueinander verlaufen. Der Nachweis ist dadurch auf einen Teilvolumen beschränkt, dessen Lage und Größe durch die Frequenz dieser Impulse, ihre Bandbreite sowie die Stärke des Gradienten bestimmt ist. Vor und nach den Impulsen HF5..HF7 sind die Gradentenfelder Gx, Gy und Gz vorzugsweise mit vergrößerter Amplitude und solchem zeitlichen Verlauf wirksam, daß das zeitliche Integral über das magnetische Gradientenfeld bis zur Mitte des zugeordneten Impulses genauso groß ist wie das zeitliche Integral über das Gradientenfeld nach diesem Zeitpunkt. Auf die Kernmagnetisierung innerhalb des selektierten Teilvolumens hat der zeitliche Verlauf der Gradientenfelder Gx..Gz keinen Einfluß, jedoch auf die Kernmagnetisierung in dem außerhalb des Teilvolumens liegenden Untersuchungsbereich, die dadurch dephasiert wird.

Der Hochfrequenzimpuls HF4 und das dazu zeitlich symmetrisch verlaufende Gradientenfeld Gz werden in der Mitte eines Zeitraums T erzeugt, der bei der Mitte des Hochfrequenzimpulses HF2 einsetzt. Das sich im selektierten Teilvolumen entwickelnde Kernresonanzsignal wird gemäß der fünfte Zeile von Fig. 4 in einem Zeitintervall abgetastet, dessen Mitte vom Ende des Zeitraums T den zeitlichen Abstand $(2N+1)/2J$ hat, wobei N eine ganze Zahl ist, vorzugsweise 0 oder 1. In dem erwähnten Abtastintervall ist der Taktgeber 16 freigegeben, so daß das in den Niederfrequenzbereich transponierte, digitalisierte Kernresonanzsignal im Rechner 17 einer diskreten Fouriertransformation unterzogen werden kann, vorzugsweise nachdem die nach vielmaliger Wiederholung der beschriebenen Sequenz im Abtastintervall erfaßten Kernresonanzsignale summiert worden sind.

Im vorliegenden Ausführungsbeispiel wurden als frequenzselektive Hochfrequenzimpulse binomiale Hochfrequenzimpulse verwendet, jedoch können auch andere frequenzselektive Impulse benutzt werden, beispielsweise die sogenannten DANTE-Impulse. Der Winkel, um den die Kernmagnetisierung der Komponenten M2 bzw. L1 usw. durch den Hochfrequenzimpuls HF4 gekippt wird, muß nicht notwendigerweise 180° betragen; er kann auch kleiner sein, dann nimmt allerdings auch die Amplitude der Kernresonanzsignale ab.

**Patentansprüche**

1. Kernresonanz-Spektroskopieverfahren, bei dem eine Sequenz - vorzugsweise mehrmals - auf einen Untersuchungsbereich einwirkt, die zwei frequenzselektive, die Wasserkomponente nicht anregende Hochfrequenzimpulse (HF1, HF2) umfaßt, zwischen denen sich ein 180°-Hochfrequenzimpuls (HF3) befindet, dadurch gekennzeichnet, daß dem zweiten frequenzselektiven Hochfrequenzimpuls ein weiterer frequenzselektiver, die Wasserkomponente (W) nicht anregender Hochfrequenzimpuls (HF4) folgt und daß zwischen dem zweiten frequenzselektiven Hochfrequenzimpuls (HF2) und dem weiteren Hochfrequenzimpuls (HF4) sowie nach dem weiteren Hochfrequenzimpuls (HF4) ein magnetisches Gradientenfeld (Gz) derart ein- und ausgeschaltet wird, daß die zeitlichen Integrale über dieses Gradientenfeld vor- und nach dem weiteren Hochfrequenzimpuls einander gleich sind.

2. Verfahren nach Anspruch 1, (HF4) dadurch gekennzeichnet, daß der weitere Hochfrequenzimpuls (HF4) ein 180°-Impuls ist.

3. Verfahren nach Anspruch 1 oder 2, dadurch gekennzeichnet, daß der weitere frequenzselektive Hochfrequenzimpuls ein binomialer Hochfrequenzimpuls (HF4) ist.

4. Verfahren nach einem der Ansprüche 1 bis 3, dadurch gekennzeichnet, daß dem weiteren frequenzselektiven Hochfrequenzimpuls drei 180°-Hochfrequenzimpulse (HF5, HF6, HF7) in Anwesenheit jeweils eines magnetischen Gradientenfeldes folgen und daß die Gradienten (Gx, Gy, Gz) der während dieser 180°-Hochfrequenzimpulse wirksamen magnetischen Gradientenfelder senkrecht zueinander stehen.

5. Anordnung zur Durchführung des Verfahrens nach Anspruch 1 mit Mitteln (1) zur Erzeugung eines homogenen stationären Magnetfeldes, mit einer Hochfrequenzspulenanordnung (11) zum Erzeugen von Hochfrequenzimpulsen und zum Aufnehmen der als Reaktion darauf im Untersuchungsbereich erzeugten Kernresonanzsignale, einer Verarbeitungseinheit zum Ableiten eines Spektrums aus den aufgenommenen Kernresonanzsignalen und mit einer Steuereinheit (15) dadurch gekennzeichnet, daß die Steuereinheit (15) so ausgebildet ist, daß sie mindestens eine Sequenz erzeugt, bei der auf einen ersten frequenzselektiven 90°-Hochfrequenzimpuls (HF1) zur Wasserunterdrückung ein 180°-Impuls (HF3) folgt, dem seinerseits ein zweiter frequenzselektiver 90°-Hochfrequenzimpuls (HF2) zur Wasserunterdrückung folgt, wonach ein magnetisches Gradientenfeld (Gz) einund ausgeschaltet wird, worauf ein weiterer frequenzselektiver Hochfrequenzimpuls (HF4) folgt, wonach das magnetische Gradientenfeld (Gz) erneut ein- und ausgeschaltet wird.

FIG.1

FIG.2

FIG.3

FIG.4